# EUROPEAN PATENT APPLICATION

(11) **EP 4 485 507 A1**
(43) Date of publication of application: **01.01.2025**
(21) Application number: 23182044.0
(22) Date of filing: 28.06.2023
(51) Int. Cl.: H01L 21/48, H01L 21/56, H01L 23/31, H01L 23/495

(54) **METHOD OF MANUFACTURING SEMICONDUCTOR ASSEMBLIES**

(71) Applicant: Nexperia B.V., 6534 AB Nijmegen (NL)
(72) Inventor: Lam, Hiu Hay Nichole, Hong Kong (HK); Yip, Shu-ming, Hong Kong (HK); Leung, Chi Ho, Hong Kong (HK); Yeung, Shun Tik, Hong Kong (HK)
(74) Representative: Pjanovic, Ilija

(57) **Abstract**

A method of manufacturing semiconductor assemblies, the method comprising forming an array of semiconductor assemblies, the semiconductor assemblies including encapsulant having frangible connections between adjacent semiconductor assemblies; and applying force to the semiconductor assemblies to break the frangible connections and thereby singulate the semiconductor assemblies.

## Description

### FIELD

The present invention relates to a method of manufacturing semiconductor assemblies, and to a semiconductor assembly.

### BACKGROUND

Semiconductor assemblies, such as transistors, are manufactured as layered assemblies including components such as semiconductor dies, die paddles, leads and an encapsulant. The encapsulant provides a protective functionality and at least partially surrounds the semiconductor die and other components forming part of the semiconductor assembly. The encapsulant may otherwise be referred to as a casing or housing.

Manufacturing of semiconductor assemblies typically comprises forming semiconductor dies using lithography, then attaching the semiconductor dies to die paddles. The die paddles are formed as an array extending from a leadframe. Once the semiconductor dies have been attached to the die paddles, leads are provided on an opposite side of the semiconductor dies from the die paddles. An encapsulant is then formed over each semiconductor die and the other components. A portion of the die paddle and a portion of the leads may extend out from the encapsulant. The semiconductor die, other components and encapsulant may be referred to as a semiconductor assembly. An array of semiconductor assemblies is formed, each semiconductor assembly being attached to the leadframe. Finally, the semiconductor assemblies are separated from the leadframe. This may be referred to as singulation.

A disadvantage of the above method is that it may be difficult to form the encapsulant for each semiconductor die. It has been proposed to form a single encapsulant which covers a row of semiconductor dies, and to then cut through the single encapsulant in order to form individual encapsulants. This may make formation of the encapsulant easier. A disadvantage of this proposed method is that a saw used to cut the encapsulant will suffer considerable wear. A further disadvantage is that as soon as the encapsulant is cut the semiconductor assembly will fall away from the leadframe, and it may be difficult to handle semiconductor assemblies formed in this way.

There exists a need to overcome the disadvantages associated with existing semiconductor assemblies, and associated methods of manufacture, whether mentioned in this document or otherwise.

### SUMMARY

According to a first aspect of the invention there is provided a method of manufacturing semiconductor assemblies, the method comprising forming an array of semiconductor assemblies, the semiconductor assemblies including encapsulant having frangible connections between adjacent semiconductor assemblies; and applying force to the semiconductor assemblies to break the frangible connections and thereby singulate the semiconductor assemblies.

Advantageously, the semiconductor assemblies remain connected until the frangible connections are broken, thereby allowing easier handling of the semiconductor assemblies.

The encapsulant may be formed without frangible connections, and wherein cutting is used to cut into the encapsulant and thereby form the frangible connections.

The cutting may be performed from above the semiconductor assemblies. The cutting may be performed from below the semiconductor assemblies.

The encapsulant may be formed with frangible connections.

The frangible connections may be tabs with a thickness of at least 0.1 mm.

The frangible connections may be tabs with a thickness of up to 3mm.

The encapsulant may be formed using a mould.

The non-lead bearing sides of the encapsulant may comprise inwardly tapering upper sides.

A lower surface of the encapsulant may be connected to non-lead bearing sides of the encapsulant by a curved edge or chamfered edge.

Non-lead bearing sides of the encapsulant may comprise vertical sides which extend from the frangible connections.

According to a second aspect of the invention, there is provided a semiconductor assembly comprising a die held in an encapsulant, with leads extending out of the encapsulant, wherein non-lead bearing sides of the encapsulant include a portion which has been formed by breaking a frangible connection.

Advantageously, manufacture of the semiconductor assembly may have been performed more easily than using conventional methods, with no detrimental effect upon the semiconductor assembly.

The portion formed by breaking the frangible connection may have a rougher surface than other portions of the encapsulant.

The portion formed by breaking the frangible connection may comprise a broken frangible tab which projects from a non-lead bearing side of the encapsulant.

The portion formed by breaking the frangible connection may comprise a broken frangible tab which is generally flush with a non-lead bearing side of the encapsulant.

Upper non-lead bearing sides of the encapsulant may include inwardly tapering upper sides.

The optional and/or preferred features of each aspect of the invention as set out herein are also applicable to any other aspects of the invention where appropriate.

### BRIEF DESCRIPTION OF THE DRAWINGS

Embodiments of the present invention will now be described, by way of example only, with reference to the accompanying drawings in which:
- Figures 1-8 schematically depict a process of forming semiconductor assemblies according to an embodiment of the invention;
- Figures 9A and 9B schematically depict a semiconductor assembly according to an embodiment of the invention;
- Figures 10A-10C schematically depict a process of separating semiconductor assemblies according to an embodiment of the invention
- Figures 11A and 11B schematically depict a semiconductor assembly according to an alternative embodiment of the invention;
- Figures 12A-12Cschematically depict a semiconductor assembly according to a further embodiment of the invention; and
- Figures 13A-13D schematically depict a process of separating semiconductor assemblies according to a further embodiment of the invention.

### DETAILED DESCRIPTION

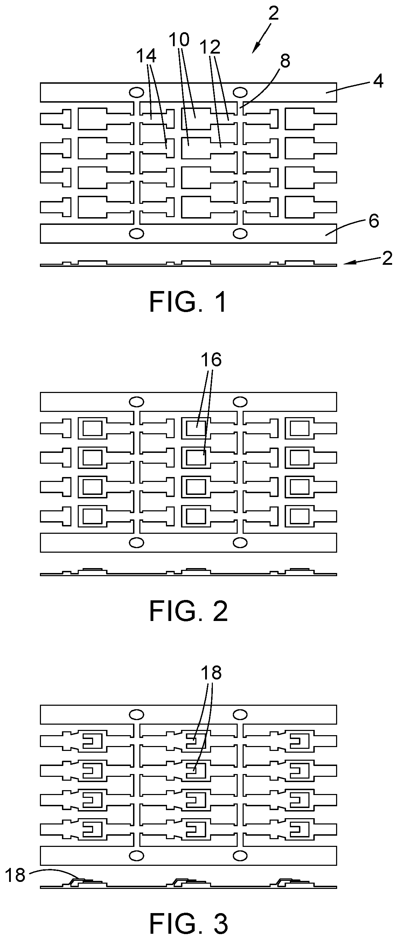

Figures 1 to 8 schematically depict a process of forming semiconductor assemblies according to an embodiment of the invention. Each figure depicts the process viewed from above and viewed in cross-section.

A leadframe 2 is depicted in Figure 1. The leadframe 2 is formed from metal, for example copper. The leadframe 2 comprises first and second bars 4, 6 which are connected by connection bars 8 that extend between the bars. Die paddles 10 are connected to the connection bars via leads 12 which extend from the die paddles 10 to the connection bars 8. Additional leads 14 extend from the connection bars 8. The additional leads 14 extend towards the die paddles 10 but do not reach the die paddles (there is a gap between the additional leads and the die paddles).

Referring to Figure 2, a die 16, which may for example be a MOSFET is bonded to each die paddle 10. The dies 16 may for example be attached to the die paddles 10 using solder.

Referring to Figure 3, a wire or clip 18 is bonded to an upper surface of each die 16 and is connected to a respective additional lead 14. In this way a lead 12 is connected to one side of a die 16 and an additional lead 14 is connected to an opposite side of the die.

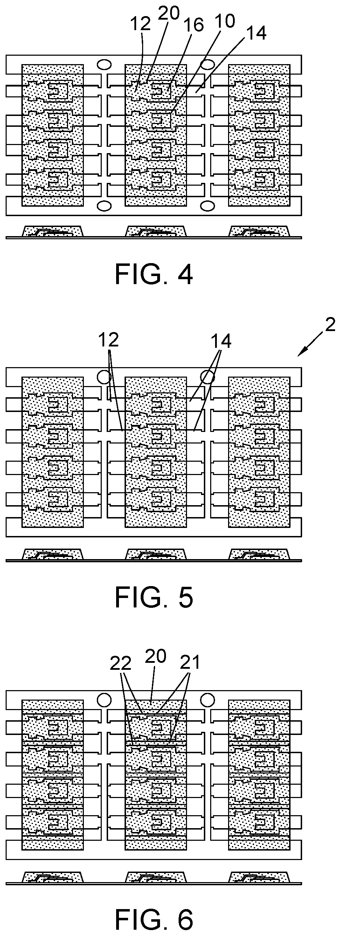

Referring to Figure 4, an encapsulant 20 (which may be referred to as a casing) is formed around the dies 16, paddles 10, and portions of the leads 12 and additional leads 14. The encapsulant 20 may be formed for example using injection molding. The encapsulant may for example be polymer. The encapsulant 20 extends between the first and second bars 4, 6. Each encapsulant encapsulates multiple dies. In the depicted example each encapsulant 20 encapsulates four dies 16 and associated components.

Referring to Figure 5, tin (Sn) plating is applied to the exposed portions of the leadframe 2, leads 12 and additional leads 14. The tin plating is solderable, and thus facilitates subsequent connection of semiconductor assemblies to other electric components.

Referring to Figure 6, a cut is made partway through the encapsulant 20 (e.g. using a saw). The cut forms grooves 21 in the encapsulant 20. The grooves 21 formed in the encapsulant run generally parallel to the first and second bars 4, 6. The grooves 21 run generally parallel to the leads 12 and additional leads 14. Encapsulant material below the grooves 21 may be referred to as tabs 22. The encapsulant material below the grooves 21 is frangible. Thus, the tabs 22 may be referred to as frangible tabs.

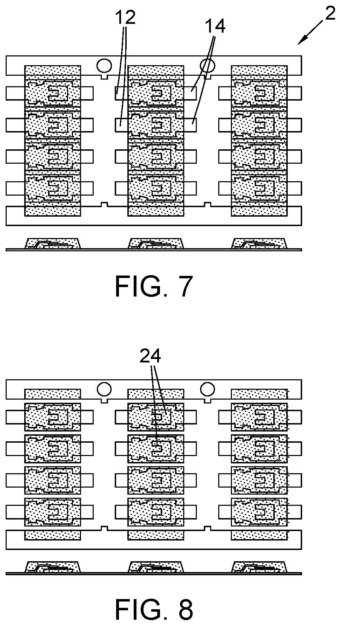

Referring to Figure 7, a punch (not depicted) is used to punch away the connection bars 8 of the leadframe 2, and optionally portions of the leads 12 and additional leads 14.

Referring to Figure 8, a punch is then used to singulate the semiconductor assemblies 24. In other words, the punch is used to separate the semiconductor assemblies 24 from each other. The punch presses against the tabs 22 of encapsulant 20 that connect the semiconductor assemblies. This breaks the tabs 22, thereby separating the semiconductor assemblies 24. The use of the punch is described in more detail further below..

Referring again to Figure 6, the grooves 21 which are formed in the encapsulant 20 are such that the remaining thickness of the encapsulant 20 is sufficiently thin to be frangible. In other words, the tabs 22 of encapsulant are frangible. Thus, the grooves 21 are provided with sufficient depth that when punch presses against the semiconductor assemblies 24, the encapsulants 20 of each semiconductor assembly will break away from each other. The encapsulants break away from each other along lines which correspond with the positions of the grooves 21. The encapsulants break away from each other in a manner which does not damage the encapsulants 20 (e.g. does not expose a portion of a die 16). This also applies for other embodiments.

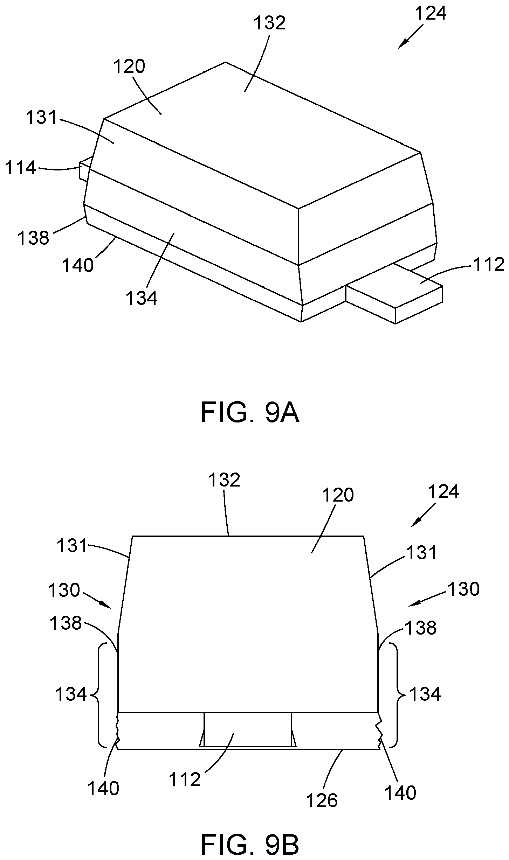

A semiconductor assembly 124 formed according to an embodiment of the invention is depicted in Figures 9A and 9B. Figure 9A depicts the semiconductor assembly 124 in perspective view, and Figure 9B depicts the semiconductor assembly viewed from one end. The semiconductor assembly 124 may be seen to comprise an encapsulant 120 from which first and second leads 112, 114 extend. Other parts of the semiconductor assembly such as the die are not visible. Figure 9B provides a clear view of a shape of non-lead bearing sides 130 of the encapsulant 120 (i.e. sides from which leads 112, 114 do not extend).

Referring to Figure 9B, sides 130 of the encapsulant 120 include an upper portion 131 which tapers inwardly towards an upper surface 132 of the encapsulant. The upper surface 132 of the encapsulant 120 is flat. The sides 130 of the encapsulant further comprise a lower portion 134 which is not tapered (is vertical when the semiconductor assembly 124 has the depicted orientation). Thus, the encapsulant 120 comprises vertical lower sides 134 which connect to inwardly tapering upper sides 131. A lower surface 136 of the encapsulant 120 is flat. At least a portion of lower surfaces of the first and second leads 112, 114 may remain exposed and not covered by the encapsulant 120.

Referring to Figures 6 and 9 in combination, an upper part 138 of the vertical sides 134 of the encapsulant 120 is formed by cutting the encapsulant 120 (e.g. using a saw). Thus, the upper part 138 of the vertical sides 134 depicted in Figure 9 each comprises one side of the groove 21 formed using the saw (see Figure 6). A lower part 140 of the vertical sides has not been cut using the saw. Instead, this lower part 140 has been formed by pressing against the encapsulant 120 such that the encapsulant 120 breaks away from an adjacent encapsulant (not depicted). Thus, the cutting of the upper part 138 of the vertical sides 134 leaves a remaining connection between adjacent encapsulants 120 which is frangible. The frangible connection (which may be referred to as a frangible tab) is broken by pressing against the encapsulant, e.g. using a punch or other apparatus designed to break encapsulants apart. It is the breaking of this frangible connection which provides the lower part 140 of the vertical sides 131. The lower part 140 of the vertical sides may comprise an irregular surface because it has been formed by breaking a frangible connection and not formed by cutting. In other words, the lower part 140 of the vertical sides may have a rougher surface than the upper part 138 of the vertical sides.

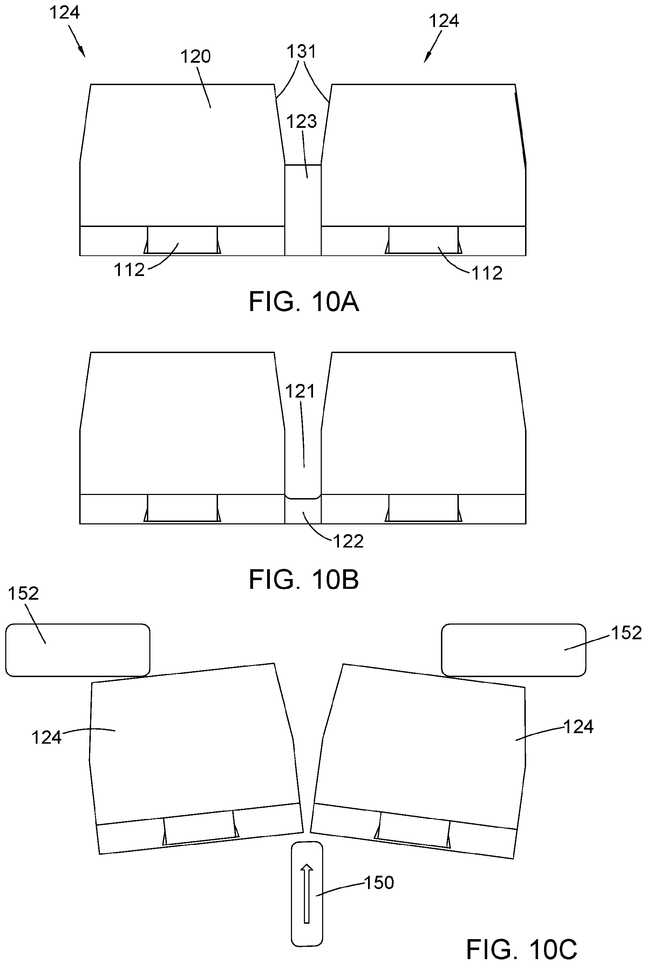

Figures 10A-C schematically depict the steps of Figures 5-8, viewed from one side, for the semiconductor assembly depicted in Figures 9A and 9B.

In Figure 10A, encapsulant 120 has been provided over two semiconductor assemblies 124. The encapsulant includes inwardly tapering upper sides 131. Beneath the inwardly tapering upper sides 131, encapsulant 120 extends between the semiconductor assemblies as a tab 123.

In Figure 10B, part of the tab is cut (e.g. using a saw), to form a groove 121 between the two semiconductor assemblies 124. This provides the sides 130 of the encapsulant with a lower portion 134 which is not tapered (is vertical when the semiconductor assembly 124 has the depicted orientation). A frangible tab 122 remains. The frangible tab 122 connects the semiconductor assemblies 124.

In Figure 10C, a punch 150 is used to separate the semiconductor assemblies 124 by breaking the frangible tab 122. Supports 152 are provided on an opposite side of the semiconductor assemblies 124 from the punch 150. The supports 152 may be laterally spaced away from the punch 150. When the punch presses against the frangible tab 122 this induces a bending of the frangible tab until the frangible tab breaks (as depicted). The semiconductor assemblies 124 are thereby separated from each other. This separation may be referred to as singulation.

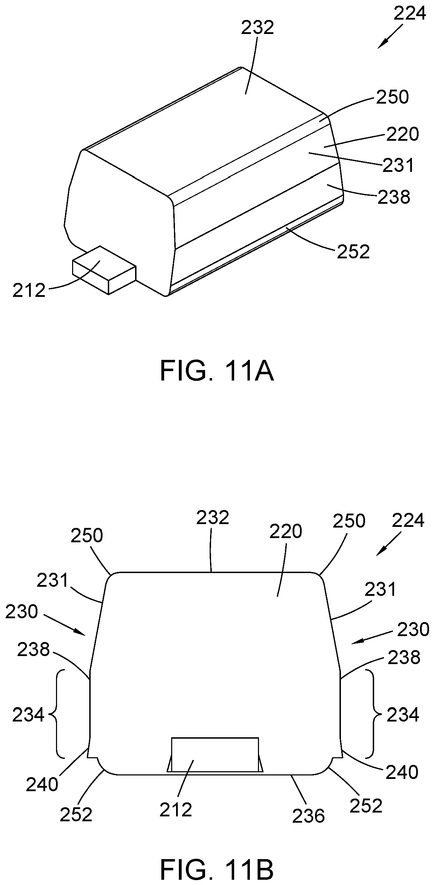

An alternative embodiment of a semiconductor assembly 224 is depicted in Figures 11A and 11B. In the alternative embodiment, an encapsulant 220 is again provided, with first and second leads extending from the encapsulant. In the figures only the first lead 212 is visible. In common with the embodiment depicted in Figures 9A and 9B, the encapsulant 220 includes non-lead bearing sides 230. The non-lead bearing sides 230 comprise vertical lower sides 234 which connect to inwardly tapering upper sides 231. A radiussed edge 250 joins the inwardly tapering upper sides 231 to an upper surface 232 of the encapsulant 220.

An upper part 238 of the vertical sides 234 is formed by cutting the encapsulant 220 (e.g. using a saw). The upper part 238 of the vertical sides 234 comprises one side of the groove 21 formed by the cut (see Figure 6). A lower part 240 of the vertical sides 234 has not been cut using the saw, but instead is frangible and has been formed by pressing against the encapsulant 220 such that the encapsulant 220 breaks away from an adjacent encapsulant (not depicted).

The encapsulant further comprises radiussed edges 252 which connect a lower surface 236 to the lower part 240 of the vertical sides 234. The radiussed edges 252 may reduce a thickness of the frangible connection between the encapsulant 220 to adjacent encapsulant (compared with the thickness that will be present if the edges were not radiussed). The radiussed edges may also help to guide breaking of the encapsulants, so that the breaking does not for example extend across a body of encapsulant.

In alternative embodiments (not depicted) the edges which connect the lower surface 236 of the encapsulant 220 to the lower part 240 of the vertical sides (the frangible part) may be chamfered, or have some other form which includes an upwardly extending component.

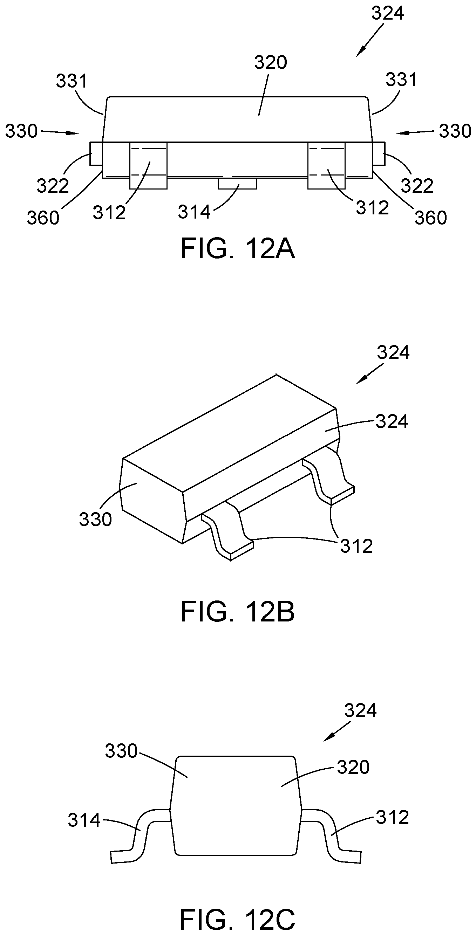

Figures 12A-C depict a semiconductor assembly 324 according to a further alternative embodiment of the invention. In Figures 11A-C, an encapsulant 320 is shown along with gull-wing leads 312, 314. The gull-wing leads 312, 314 extend from part-way up the encapsulant 320 instead of at the bottom of the encapsulant (as is the case for the embodiments of Figures 9A,B and 11A,B). The gull-wing leads 312, 314 include bends instead of being straight.

The encapsulant 320 has non-lead bearing sides 330. The non-lead bearing sides 330 include inwardly tapering upper sides 331. Lower sides 334 of the encapsulant 320 include a generally vertical lower portion 360. An upper portion of the lower sides 334 comprises broken frangible tabs 322. As depicted in Figure 12A, the broken frangible tabs 322 may project from sides 330 of the encapsulant 320. In other embodiments, the broken frangible tabs may be generally flush with the sides 330 of the encapsulant.

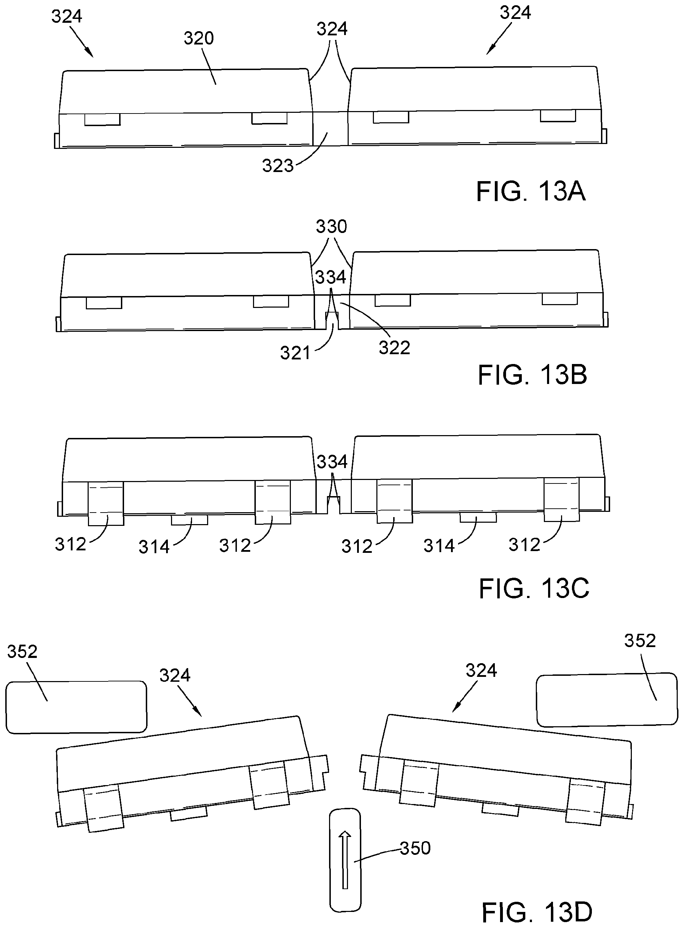

Figures 13A-D schematically depict the steps of Figures 5-8, viewed from one side, for the semiconductor assembly depicted in Figures 11A-C.

In Figure 13A, encapsulant 320 has been provided over two semiconductor assemblies 324. The encapsulant includes inwardly tapering upper sides 324. Beneath the inwardly tapering upper sides 324, encapsulant 320 extends between the semiconductor assemblies as a tab 323.

In Figure 13B, part of the tab 323 is cut (e.g. using a saw), to form a groove 321 between the two semiconductor assemblies 324. The cut is provided from below the semiconductor assemblies 324. This cut provides the sides 330 of the encapsulant with a generally vertical lower portion 334 (i.e. vertical when the semiconductor assembly 324 has the depicted orientation). A frangible tab 322 remains. The frangible tab 322 connects the semiconductor assemblies 324.

In Figure 13C, leads 312, 314 of the semiconductor assemblies 324 are bent to desired shapes. The step is optional. It may be performed at a different point in the process. Alternatively, the step may be omitted if straight leads are desired.

In Figure 13D, a punch 350 is used to separate the semiconductor assemblies 324 by breaking the frangible tab 322. Supports 352 are provided on an opposite side of the semiconductor assemblies 324 from the punch 350. The supports 352 may be laterally spaced away from the punch 350. When the punch presses against the frangible tab 322 this induces a bending of the frangible tab until the frangible tab breaks (as depicted). The semiconductor assemblies 324 are thereby separated from each other.

The encapsulant 120, 220, 320 may be polymer. The encapsulant 120, 220, 320 may be injection molded. This allows the encapsulant to be provided with any desirable shape without incurring significant additional expense.

Some embodiments of the invention have been described as including radiussed edges. In general, any form of edge may be provided. For example, a curved edge, chamfered edge, sharp edge, etc.

Embodiments of the invention comprise a frangible connection between adjacent encapsulants (which may alternatively be referred to as frangible tabs). The frangible connection may be considered to be a connection which is configured to snap when force is applied to one or more adjacent encapsulants. Configured to snap may be interpreted as meaning that the encapsulants will break from each other without exposing the die or other internal parts of the semiconductor assembly. Configured to snap may be interpreted as meaning that a break between encapsulants follows a predetermined path (e.g. along the path of the sawn groove). Snapping is a form of breaking. Snapping may be considered to mean a break which occurs substantially simultaneously along and through a connection. This compares with cutting, where for example a cut may begin at one end of a connection and then travel along that connection.

The frangible tabs 22, 222, 322 may have a thickness of around 0.2mm. The frangible tabs 22, 222, 322 may for example have a thickness of at least 0.05mm. A frangible tab with a thickness of less than 0.05m may not be strong enough to reliably hold the semiconductor assemblies together before singulation is desired. The frangible tabs 22, 222, 322 may for example have a thickness of up to 0.3mm. A tab with a thickness of more than 0.3mm may not be reliably frangible (i.e. it may be difficult to break a thicker tab, and the thicker tab may fail to break in some cases).

In described embodiments, a cutting step is used to reduce the thickness of the encapsulant connection between adjacent semiconductor assemblies. The cutting may be performed from above or below the semiconductor assemblies.

In other embodiments, a cutting step is not required. For example, the encapsulant may be formed with a frangible encapsulant connection between adjacent semiconductor assemblies (e.g. by tapering sides of adjacent encapsulants).

In a semiconductor assembly made according to an embodiment of the invention, a surface of a non-lead bearing side may include a relatively smooth portion (e.g. formed by moulding or cutting) and a rougher portion formed by breaking a frangible connection. The relatively rough portion may project from a wall of the semiconductor assembly, or may be generally flush with a wall of the semiconductor assembly.

Depicted embodiments show breaking of frangible connections between semiconductor assemblies. Breaking of frangible connections between semiconductor assemblies and a lead frame may be performed in a corresponding manner.

## Claims

1. A method of manufacturing semiconductor assemblies, the method comprising:
forming an array of semiconductor assemblies, the semiconductor assemblies including encapsulant having frangible connections between adjacent semiconductor assemblies; and
applying force to the semiconductor assemblies to break the frangible connections and thereby singulate the semiconductor assemblies.

2. The method of claim 1, wherein the encapsulant is formed without frangible connections, and wherein cutting is used to cut into the encapsulant and thereby form the frangible connections.

3. The method of claim 2, wherein the cutting is performed from above the semiconductor assemblies.

4. The method of claim 1, wherein the encapsulant is formed with frangible connections.

5. The method of any preceding claim, wherein the frangible connections are tabs with a thickness of at least 0.1mm.

6. The method of any preceding claim, wherein the frangible connections are tabs with a thickness of up to 3mm.

7. The method of any preceding claim, wherein the encapsulant is formed using a mould.

8. The method of any preceding claim, wherein non-lead bearing sides of the encapsulant comprise inwardly tapering upper sides.

9. The method of any preceding claim, wherein a lower surface of the encapsulant is connected to non-lead bearing sides of the encapsulant by a curved edge or chamfered edge.

10. The method of any preceding claim, wherein non-lead bearing sides of the encapsulant comprise vertical sides which extend from the frangible connections.

11. A semiconductor assembly comprising a die held in an encapsulant, with leads extending out of the encapsulant, wherein non-lead bearing sides of the encapsulant include a portion which has been formed by breaking a frangible connection.

12. The semiconductor assembly of claim 11, wherein the portion formed by breaking the frangible connection has a rougher surface than other portions of the encapsulant.

13. The semiconductor assembly of claim 11 or claim 12, wherein the portion formed by breaking the frangible connection comprises a broken frangible tab which projects from a non-lead bearing side of the encapsulant.

14. The semiconductor assembly of claim 11 or claim 12, wherein the portion formed by breaking the frangible connection comprises a broken frangible tab which is generally flush with a non-lead bearing side of the encapsulant.

15. The semiconductor assembly of any of claims 11 to 14, wherein upper non-lead bearing sides of the encapsulant include inwardly tapering upper sides.
